Europäisches Patentamt

European Patent Office

Office européen des brevets

(11) Publication number: **0 372 092**
**A1**

## EUROPEAN PATENT APPLICATION
## published in accordance with Art. 158(3) EPC

(21) Application number: 89907276.3

(22) Date of filing: 15.06.89

(86) International application number:
PCT/JP89/00600

(87) International publication number:
WO 89/12912 (28.12.89 89/30)

(51) Int. Cl.5: **H01L 29/84, H01L 21/22**

(30) Priority: 15.06.88 JP 147102/88

(43) Date of publication of application:
13.06.90 Bulletin 90/24

(84) Designated Contracting States:
DE FR GB NL

(71) Applicant: **KABUSHIKI KAISHA KOMATSU SEISAKUSHO**
**3-6, Akasaka 2-chome**
**Minato-ku Tokyo 107(JP)**

(72) Inventor: **HATA, Y. c/o The Research Inst.,K.K.Komatsu Seisa.**
**1200, Manda,Hiratsuka-shi**
**Kanagawa-ken 254ken 254(JP)**
Inventor: **INAGAKI, H. c/o The Research Inst., K.K.Komatsu S.**
**1200, Manda,Hiratsuka-shi**
**Kanagawa-ken 254(JP)**
Inventor: **SUZUNO, Y. c/o The Research Inst.,K.K.Komatsu Sei.**
**1200, Manda,Hiratsuka-shi200, Manda**
**Kanagawa-ken 254(JP)**

(74) Representative: **Newstead, Michael John et al**
**Page & Co. Temple Gate House Temple Gate**
**Bristol BS1 6PL(GB)**

(54) STRESS CONVERSION DEVICE AND ITS PRODUCTION METHOD.

(57) In the stress conversion device of the present invention, a strain gauge pattern is composed of an impurity region formed by selectively applying laser to the surface of a semiconductor substrate forming at least part of a strain generation portion. In a production method of a stress conversion device of the present invention, a strain gauge is formed by the steps of introducing an impurity into the surface of a semiconductor substrate constituting at least part of a strain generation portion, applying laser to the semiconductor substrate into which the impurity has been introduced and forming a strain gauge consisting of the impurity region pattern.

FIG.1(a)

SPECIFICATION

## STRESS TRANSDUCER AND METHOD OF PRODUCING THE SAME

### Technical Field

This invention relates to a stress transducer and a method of producing the same, and more particularly, to the structure of a strain gauge thereof and a method of producing the same.

### Background Art

In accordance with progress in semiconductor technology, semiconductor sensors utilizing piezoresistive effect of semiconductors, such as silicon, germanium and the like, are recently attracting notice.

In such semiconductor sensors, a semiconductor strain gauge is provided on a strain producing member, such as a cantilever, a diaphragm or the like, an amount of strain produced in the strain producing member is detected by the semiconductor strain gauge, and the detected signal is output as an electric signal. The semiconductor sensors are used in the measurement of pressure, acceleration, load and the like.

It is considered that the sensitivity of the semiconductor strain gauge (that is, the ratio of the amount of change in the value of resistance to the amount of strain) is superior in single-crystal thin films or polycrystal

1

films which have excellent crystallinity, and that sensitivity for p-type or n-type semiconductors containing impurities is superior to that for intrinsic semiconductors. Accordingly, sensors are being used in which, for example, a pattern of an impurity diffused layer having a desired conduction type is formed within a single-crystal substrate to configure a strain gauge, or a pattern of a polycrystal thin film doped to a desired conduction type is formed to configure a strain gauge.

Among them, as sensors for measuring low load, sensors utilizing single-crystal substrates are mostly used. As a typical example, there is a sensor in which a strain-gauge pattern made of an impurity diffused layer is formed on a surface of a single-crystal silicon substrate shaped in a diaphragm having a thin portion.

This diffusion-type pressure sensor is formed as follows.

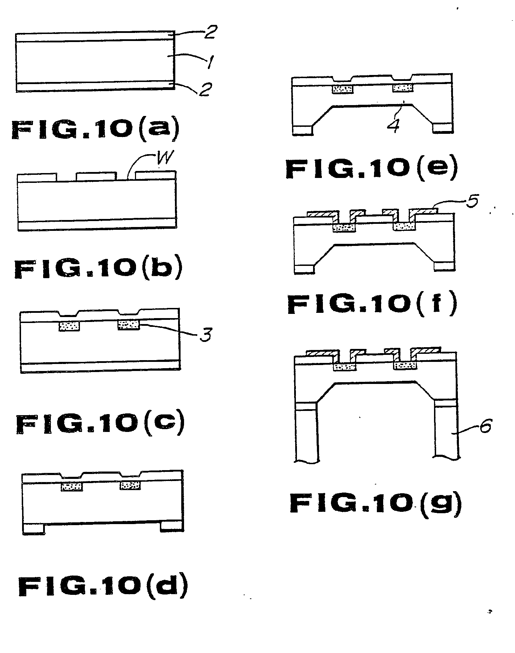

First, as shown in FIG. 10(a), surfaces of a single-crystal silicon substrate 1 are oxidized to form silicon-oxide films 2.

Next, as shown in FIG. 10(b), a window W for diffusion is formed within the silicon-oxide film 2 by a photolithographic method.

Subsequently, as shown in FIG. 10(c), an impurity is diffused through the window W for diffusion to form an impurity diffused layer as a strain-gauge pattern 3.

After thus forming the strain gauge pattern 3, silicon oxide films 2 are formed again by a thermal oxidation method, front and back surfaces are then coated with resist, only resist on the back surface is selectively removed, and the silicon oxide film 2 formed on the back surface side of the substrate is subjected to patterning by utilizing the remaining silicon oxide film as a mask, as shown in FIG. 10(d).

Then, as shown in FIG. 10(e), the silicon substrate 1 is etched from the back surface side to form a thin portion 4.

Subsequently, as shown in FIG. 10(f), a metal film 5 made of aluminum or the like is formed by vacuum deposition, and the film is then subjected to patterning to form an interconnection layer 5.

Finally, the silicon substrate 1 in which a strain gauge has thus been formed is fixed on a seating 6, and a pressure sensor as shown in FIG. 10(g) is completed.

In such a pressure sensor, when pressure is applied from the back surface side of the thin portion 4 of the silicon subsrate 1 where the strain gauge is formed, the strain gauge is strained together with the thin portion 4, and a change in the value of resistance of the strain gauge caused by the strain is taken out as an electric signal.

3

Since a single-crystal silicon substrate is used, the sensor has a very high sensitivity.

As a typical sensor for measuring high load, there is a sensor in which a strain gauge made of a thin film pattern of impurity-doped polycrystal silicon is formed on a metal diaphragm made of stainless steel or the like.

This thin-film pressure sensor is formed as follows.

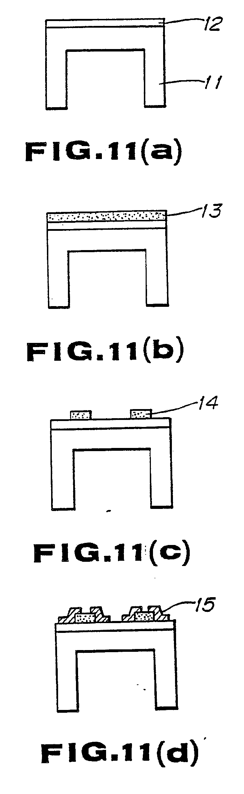

First, as shown in FIG. 11(a), a silicon oxide film 12 is formed on a stainless-steel diaphragm 11 having a thin portion as an insulating film.

Next, as shown in FIG. 11(b), an n-type or p-type polycrystal silicon film 13 is deposited on the silicon oxide film 12 by a plasma CVD method.

Subsequently, as shown in FIG. 11(c), the polycrystal silicon thin film 13 is subjected to patterning to form a strain-gauge pattern 14.

Finally, as shown in FIG. 11(d), a metal film made of aluminum or the like is formed by vacuum deposition, and the film is subjected to patterning to form an interconnection layer 15.

In this thin-film pressure sensor, the thin portion of the stainless-steel diaphragm 11 constitutes a strain-producing member, and strain produced is detected by the strain-gauge pattern made of a polycrystal silicon thin film.

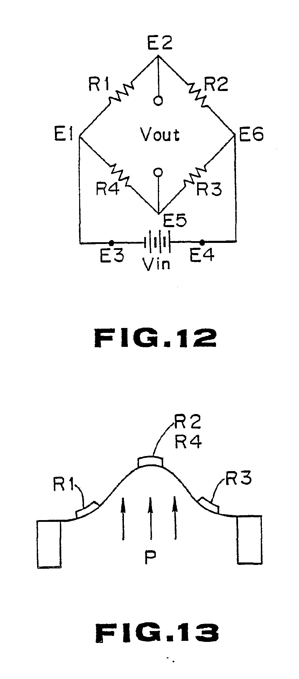

In such pressure sensors, as shown in FIG. 12, the strain-gauge pattern constitutes in general a bridge circuit, and pressure is measured by detecting a change in the voltage between patterns E2 and E5 in the interconnection layer which is produced by changes in the values of resistance in the strain gauge due to strain caused by the pressure.

That is, at the moment of no load (when there is no strain), all the values of resistance of respective gauge patterns R1 - R4 have an equal value R.

If it is assumed that pressure P is applied on the diaphragm 1 as shown in FIG. 13, since the sensor has structure in which the strain gauge patterns R1 and R3 are disposed at peripheral portions of the diaphragm and the strain gauge patterns R2 and R4 are disposed at central portions, the strain gauge patterns R1 and R3 receive compressive stress and the value of resistance becomes $R + \Delta R$. On the other hand, the strain gauge patterns R2 and R4 receive tensile stress and the value of resistance becomes $R - \Delta R$.

If it is assumed that voltage Vin is applied between electrode interconnection patterns E1 and E6, since the values of resistance of all four strain-gauge patterns R1, R2, R3 and R4 are equal at the moment of no load, the potential at the electrode interconnection patterns E2 and E5 is equal, that is, the voltage between these patterns $V = 0$.

Accordingly, when there is applied load such as the pressure P shown in FIG. 13, the value of resistance for the strain-gauge patterns R1 and R3 becomes $R + \Delta R$, the value of resistance for the strain-gauge patterns R2 and R4 becomes $R - \Delta R$, and hence the voltage between the electrode interconnection patterns E2 and E5 is

$V = 2 (\Delta R/R) \cdot Vin.$

Thus, voltage in accordance with load is output, the output voltage is subjected to processing, such as amplification and the like, at an amplifier unit (not shown), and is output to an external circuit.

However, when the former diffusion-type pressure sensor is formed, a high-temperature process of about 1000 °C is needed for a diffusion process. Hence, handling is very difficult.

Furthermore, after the formation of the strain gauge, etching for forming the thin portion is performed, and a high-temperature process (of about 1000 °C) is needed for forming the silicon oxide film as a protective layer for the etching. Hence, there are problems in that the diffused layer constituting the strain gauge is extended, and rediffusion occurs.

In order to solve these problems, there has been considered a method in which etching for forming the thin portion is performed before forming the strain gauge. However, this method also has many problems in that the substrate in which the thin portion has already been formed by etching must be exposed to a high temperature at the moment of diffusion, and hence destruction might occur due to thermal strain.

In the latter thin-film pressure sensor, when the semiconductor film constituting the strain gauge is formed, the substrate temperature must be kept at about 500 °C. Furthermore, in such a sensor, all the values of resistance for the strain-gauge patterns R1 - R4 must be identical in order to increase accuracy in detection. Hence, there is a problem in that complicated processes, such as a photolithographic process and the like, must be provided for patterning.

Accordingly, there are problems in that materials used for the strain producing member must be resistant to high temperature and chemicals, such as metal or the like, and hence only limited materials can be used. Furthermore, when the strain producing member is constituted by a conductive material, such as metal or the like, it is necessary to coat the surface with an insulating film. The insulating film must also be resistant to high-temperature process, and hence only limited materials, such as silicon oxide and the like, can be used. To make matters worse, in order to deposit a silicon oxide film to a film thickness needed, a great deal of time is required, and this causes increase in

7

cost.

The present invention has been made in consideration of circumstances as described above.

It is an object of the present invention to provide a stress transducer having low cost and high accuracy which can be formed at low temperature.

Disclosure of the Invention

The stress transducer of the present invention is constituted by an impurity region in which a strain-gauge pattern is formed by selectively performing laser irradiation upon a surface of a semiconductor substrate constituting at least a part of a strain producing member.

In the method of the present invention, a process for forming a strain gauge includes an impurity introducing process for introducing an impurity in a surface of a semiconductor substrate constituting at least a part of a strain producing member, and a laser irradiating process for performing laser irradiation upon the semiconductor substrate in which the impurity has been introduced to form a strain gauge made of a pattern of an impurity region.

The term strain producing member indicates both a member the entire body of which is constituted by a semiconductor substrate and a member only the surface of which is constituted by a semiconductor substrate and the base portion of which consists of other material.

The process for forming a strain gauge by laser irradiation in the above-described configuration is as follows.

First, when a surface of a semiconductor substrate is irradiated by laser, the irradiated region absorbs light from the surface in accordance with the wavelength of the laser and the absorption coefficient of the semiconductor substrate material.

When energy due to the light is given to the semiconductor substrate, the energy is converted into heat to cause temperature rise. When the semiconductor substrate is heated up to the melting point or more due to the temperature rise, the surface melts (the depth of melting is proportional to the irradiating energy and time).

If an impurity exists on the surface of the semiconductor substrate at this moment, the surface melts while taking in the impurity, and hence high-density doping becomes possible.

When the laser irradiation is stopped, the surface starts to cool, and the melted region resolidifies in a state doped in high density.

At this time, if the semiconductor substrate is made of a single-crystal semiconductor, the melted region performs again crystal growth in a state taking in the impurity, and a strain gauge made of an impurity diffused region doped in high density which is in a crystal state different from that of the substrate is formed.

If the semiconductor substrate is made of a polycrystal semiconductor, the melted region performs again crystal growth in a state taking in the impurity, and there is formed a strain gauge made of an impurity diffused region doped in high density having large crstal-grain size (a single crystal is sometimes obtained) which is in a crystal state different from that of the substrate.

If the semiconductor substrate is made of an amorphous semiconductor, the melted region performs again crystal growth in a state taking in the impurity to produce polycrystals or microcrystals, and a strain gauge made of an impurity diffused region doped in high density is formed.

As the process for introducing an impurity, the following three methods exist.

The first method is a method of adsorbing an impurity on a surface of a semiconductor substrate. In this method, laser irradiation is, for example, performed in an atmosphere containing the impurity to form an impurity diffused pattern (a strain gauge).

The second method is a method of forming a film containing an impurity on a surface of a semiconductor substrate. In this method, an impurity diffused pattern (a strain gauge) is formed utilizing this film as a diffusion

10

source.

The third method is a method of including an impurity into a semiconductor substrate while the semiconductor substrate is formed. In this method, a semiconductor substrate previously doped to either of conductive types is formed, and an impurity diffused pattern (a strain gauge) having low resistance is formed by selectively performing laser irradiation upon the semiconductor substrate. If the semiconductor substrate is, for example, made of a polycrystal semiconductor, the grain size of crystals becomes large only in the irradiated region, as described before, and low resistance value is obtained.

In all the cases described above, the formation of strain-gauge pattern can be performed at a low temperature without passing through a photolithographic process. Hence, production is easy.

Particularly when a semiconductor substrate is formed on a surface of a strain producing member and a strain gauge pattern is formed on the semiconductor substrate, the formation of the strain gauge pattern can be performed at a low temperature without passing through a photolithographic process, and heat-resistant and chemical-resistant properties are not required. Hence, the strain producing member may be formed by any material, and hence it is possible to reduce cost.

11

Brief Description of the Drawings

FIGS. 1(a) through 1(e) are diagrams showing a production process for a stress transducer according to a first embodiment of the present invention;

FIG. 2 is a diagram showing a laser irradiating room used in the embodiments of the present invention;

FIGS. 3(a) and 3(b) are graphs showing the relationship between the irradiation condition of laser and the strain-gauge pattern.

FIGS. 4(a) through 4(c) are diagrams showing a production process of a stress transducer according to a second embodiment of the present invention;

FIGS. 5(a) through 5(c) are diagrams showing a production process of a stress transducer according to a third embodiment of the present invention;

FIG. 6 is a diagram showing the relationship between the shot number of laser and sheet resistance;

FIGS. 7(a) through 7(c) show a first modified example of the third embodiment;

FIGS. 8(a) through 8(d) show a second modified example of the third embodiment;

FIG. 9 is a diagram showing the relationship between temperature and modulus of elasticity for crystalline engineering plastics and noncrystalline plastics;

12

FIGS. 10 and 11 are diagrams showing conventional pressure sensors;

FIG. 12 is an equivalent circuit diagram for a pressure sensor; and

FIG. 13 is a diagram for explaining an example of measurement.

Best Mode for Carrying Out the Invention

The present invention will now be explained in detail with reference to the drawings.

Example 1

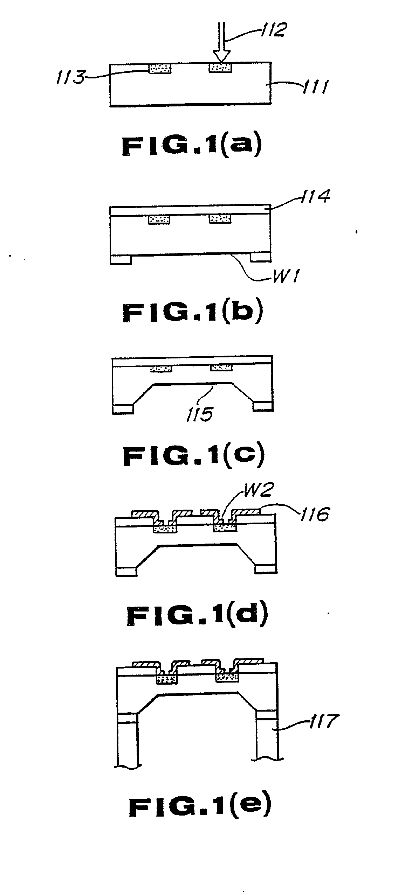

In a pressure sensor according to a first embodiment of the present invention, as shown in FIGS. 1(a) through 1(e) which represent diagrams for its production process, an n-type single-crystal silicon substrate 111 is processed in the shape of a diaphragm to provide a strain producing member, and there is provided a strain gauge 113 made of an impurity diffused pattern formed by irradiating laser light 112 upon a surface of the silicon substrate 111 in an atmosphere of $B_2H_6$ gas.

In production, the n-type single-crystal silicon substrate 111 is placed in a laser irradiating room, and the laser light 112 is projected in an atmosphere of $B_2H_6$ gas so that a desired shape of pattern is provided, as shown in FIG. 1(a).

13

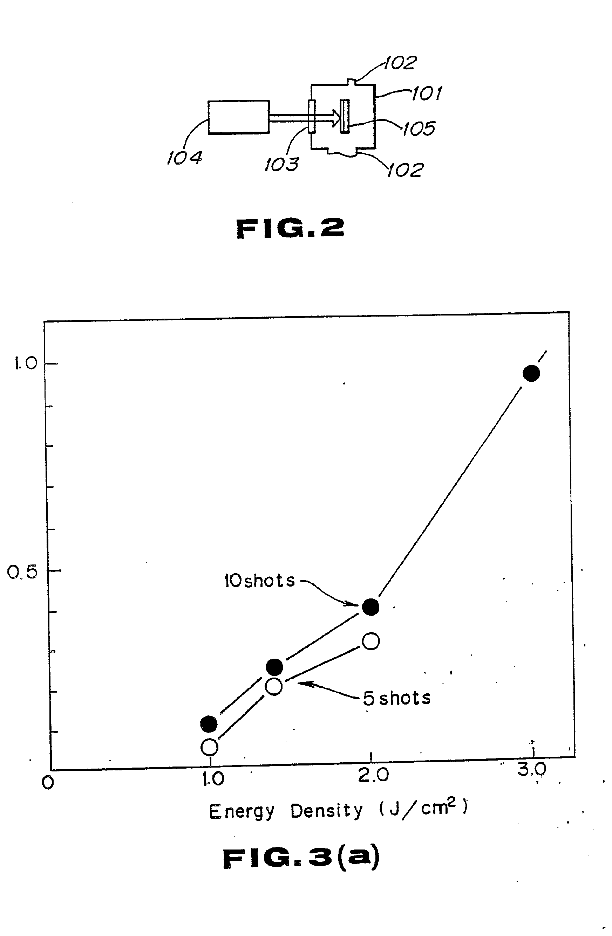

The laser irradiating room comprises the main body 101 of the irradiating room, a pipe 102 for introducing gas into the irradiating room and exhausting gas therefrom, a quartz window 103 for introducing the laser light, and a laser oscillator 104, as shown in FIG. 2, and selectively irradiates the laser light upon a surface of a sample 105 placed in the irradiating room. That is, by moving the laser light or the sample 105, it is possible to depict a fine irradiating pattern.

In this case, $B_2H_6$ gas diluted to 5 % is introduced via the pipe 102, and the interior of the main body 101 of the irradiating room is maintained at an atmosphere of 50-Torr $B_2H_6$ gas. Subsequently, 10 shots of the laser light having the energy of $1J/cm^2$ from an oscillation source of xenon-chloride eximer laser (having a wavelength of 308 nm) are projected upon a strain-gauge forming region to diffuse B into the single-crystal silicon substrate 111, and the strain gauge 113 is thus formed. At this moment, the depth of the strain gauge 113, that is diffused depth was 0.1 $\mu$m, surface density was $10^{20}$ $cm^{-3}$, and sheet resistance was 20 $\Omega/cm^2$. In this case, before the irradiation of the laser light, a protective film, such as silicon oxide or the like, may be provided so that only the strain-gauge forming region is left.

Next, as shown in FIG. 1(b), a silicon oxide film 114

14

as a mask for protecting against etching is formed on the front and back surfaces of the single-crystal silicon substrate 111 in which the strain gauge has been formed, and a window W1 for etching for processing the shape of the diaphragm is formed only on the back surface.

Then, as shown in FIG. 1(c), the single-crystal silicon substrate 111 on which the silicon oxide film 114 as the mask has been formed is etched to form a thin portion 115 in the shape of a diaphragm.

Subsequently, as shown in FIG. 1(d), a window W2 for contact to the strain gauge 113 is formed on the silicon oxide film 114 at the surface side of the single-crystal silicon substrate 111, and an interconnection pattern 116 made of an aluminum layer is formed by vacuum deposition.

Finally, as shown in FIG. 1(e), the pressure sensor is completed by bonding the single-crystal silicon substrate 111 processed in the shape of a diaphragm to a seating 117.

The pressure sensor thus formed has extremely high sensivity since a strain gauge having extremely excellent crystallinity is formed.

Furthermore, it is possible to omit a photolithographic process for the patterning of the strain gauge, and a strain-gauge pattern having high accuracy can be formed by laser irradiation without passing through a high-temperature process. Since it suffices to maintain the substrate at about room temperature without heating, strain due to heat is not produced.

In the above-described embodiment, the single-crystal silicon substrate 111 is etched to form the shape of a diaphragm after forming the strain gauge. Since the laser irradiating process does not produce high temperature, strain due to heat is not produced. Accordingly, even if the single-crystal silicon substrate is processed in the shape of a diaphragm before forming the strain gauge and laser irradiation is then performed on the surface of the single-crystal silicon substrate having the shape of a diaphragm to form the strain gauge, distortion is not produced in the diaphragm.

Since it is possible to form the strain gauge without passing through a high-temperature process in any of the above-described cases, handling is easy.

Furthermore, although an explanation has been provided of a sensor having a strain producing member having the shape of a diaphragm, strain producing member may of course have other shapes, such as a cantilever and the like.

In addition, although, in the present embodiment, laser irradiation is performed in an atmosphere of impurity gas, the semiconductor substrate may be placed in an atmosphere of impurity gas, and laser irradiation may be performed after removing the impurity gas.

16

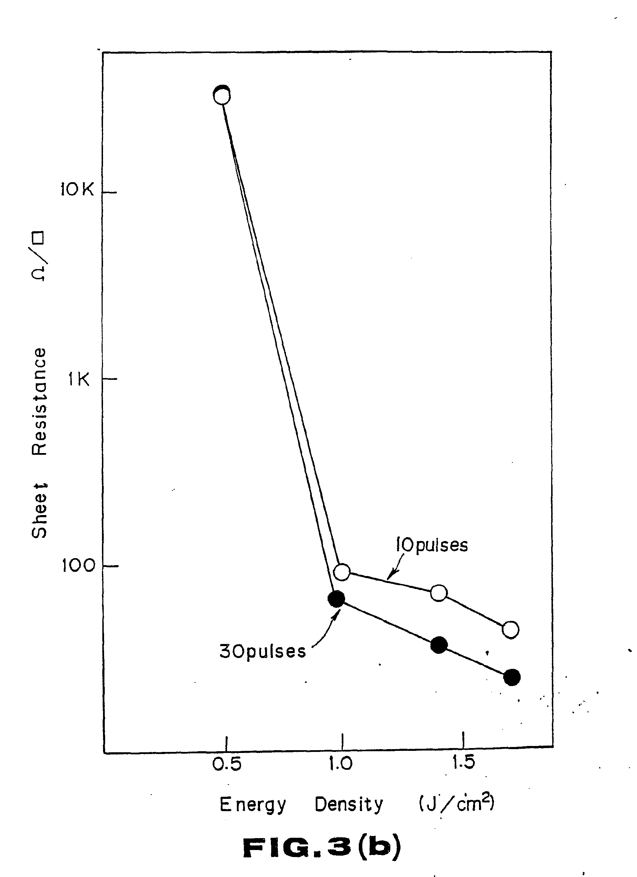

The relationship between energy density and diffused depth as a result of measurement with changing shot number is shown in FIG. 3(a). As is apparent from FIG. 3(a), diffused depth becomes larger as laser energy is larger and shot number is larger. Hence, it is possible to obtain a desired value of diffused depth (gauge depth) by adjusting laser energy and shot number.

Furthermore, the relationship between energy density and sheet resistance as a result of measurement with changing shot number is shown in FIG. 3(b). As is apparent from FIG. 3(b), sheet resistance becomes smaller as laser energy is larger and shot number is larger. Hence, it is possible to obtain a desired value of diffused depth by adjusting laser energy and shot number.

Example 2

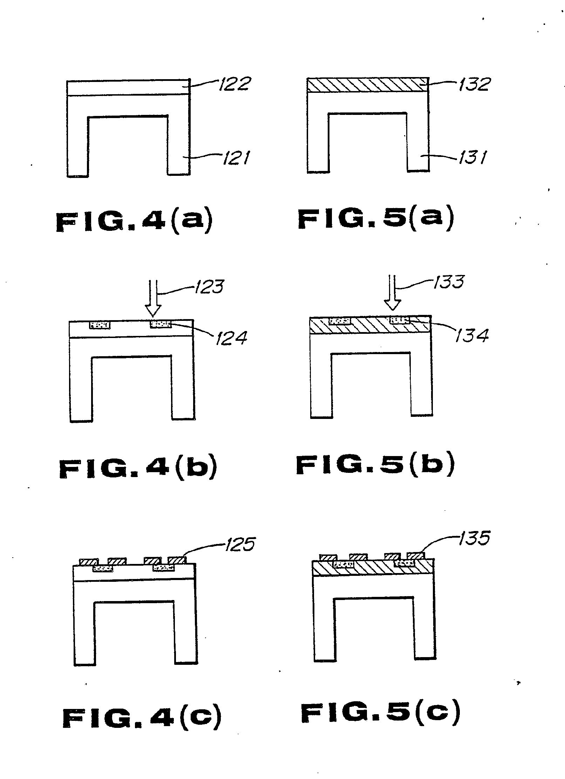

In a pressure sensor according to a second embodiment of the present invention, as shown in FIGS. 4(a) through 4(c) which represent diagrams of its production process, there is disposed a strain gauge 124 made of an impurity diffused pattern which has been formed by irradiating laser light 123 upon a polycrystal silicon thin film 122 formed on a surface of a diaphragm 121 made of stainless steel in an atmosphere of $B_2H_6$ gas.

First, as shown in FIG. 4(a), while heating the diaphragm 121 made of stainless steel at 400 °C - 500 °C, the polycrystal silicon thin film 122 is deposited by a plasma CVD method. In this case, an insulating film may be deposited before depositing the polycrystal silicon thin film 122.

Next, as shown in FIG. 4(b), the diaphragm 121 on which the polycrystal silicon thin film 122 has been formed is placed in the laser irradiating room. After exhausting air, the interior of the main body 101 of the irradiating room is maintained at an atmosphere of 50-Torr $B_2H_6$ gas, and 10 shots of the laser light 123 having the energy of 0.5 $J/cm^2$ from an oscillation source of XeCl eximer laser are projected upon a strain-gauge forming region to diffuse B into the polycrystal silicon thin film 122, and the strain gauge 124 is thus formed.

Finally, as shown in FIG. 4(c), an interconnection pattern 125 made of an aluminum layer is formed by vacuum deposition.

In such a configuration, since the polycrystal silicon thin film has high resistance, the diaphragm does not conduct with the strain gauge even if an insulating film is not formed before the formation of the interconnection pattern. Accordingly, it becomes unnecessary to form an insulating film which has been necessary for a conventional stainless-steel diaphragm as shown in FIG. 10. Hence, time required for production is largely shortened (in a conventional configuration, silicon oxide has been used as the insulating film, and it has been required about 5 hours for the deposition of the silicon oxide film).

Furthermore, if the polycrystal silicon thin film is formed sufficiently thick, it is possible to provide a sensor having sufficient breakdown voltage.

In addition, in the present embodiment, since it is unnecessary to form an insulating film on an upper layer of the strain gauge, the interconnection pattern is formed on a flat surface, and it is possible to prevent disconnection due to steps.

Moreover, a conventional configuration is made through a high-temperature process, and hence there is produced strain due to difference in coefficient of thermal expansion between stainless steel and polycrystal silicon. On the other hand, since the configuration of the present embodiment is made without passing through a high-temperature process, strain which has previously been produced is not produced, and it is possible to obtain a stress transducer having high reliability.

Thus, according to the present embodiment, it is possible to largely shorten production process, and to form a stress transducer which is easy to produce and has high reliability.

19

Example 3

In a pressure sensor according to a third embodiment of the present invention, as shown in FIGS. 5(a) through 5(c) which represent diagrams of its production process, there is disposed a strain gauge 134 made of an impurity diffused pattern which has been formed by irradiating laser light in an atmosphere of $B_2H_6$ gas within an amorphous silicon thin film 132 formed on a surface of a diaphragm 131 made of polyether sulfonic resin.

First, as shown in FIG. 5(a), on the surface of the diaphragm 131 made of polyether sulfonic resin, the amorphous silicon thin film 132 6000 Å thick is deposited by an RF sputtering method. As for deposition conditions in this case, sintered polycrystal silicon or a single-crystal wafer is used as a target, and sputtering is performed at the RF power of 300 W for 1 hour.

Next, as shown in FIG. 5(c), the diaphragm 131 on which the amorphous silicon thin film 132 has been formed is placed in the laser irradiating room. After exhausting air, the interior of the main body 101 of the irradiating room is maintained at an atmosphere of 50-Torr $B_2H_6$ gas, and 10 shots of laser light 133 having the energy of 0.2 $J/cm^2$ are projected upon a strain-gauge forming region to diffuse B into the amorphous silicon thin film 132, and a strain gauge

20

134 is thus formed. At this moment, the depth of the strain gauge 134, that is, diffused depth was 0.2 - 0.4 $\mu$m, sheet resistance was several hundreds of $\Omega/cm^2$, and resistivity was $10^{-2}$ $\Omega$ cm. It is also possible to arrange so that the depth of the strain gauge, that is, diffused length does not reach the surface of the diaphragm 131 made of plastic by controlling the thickness of the amorphous silicon thin film 132. However, since time for laser irradiation is extremely short, there arises little influence even if a region fused by laser irradiation reaches the surface of the diaphragm 131.

Finally, as shown in FIG. 5(c), an interconnection pattern 135 made of an aluminum layer is formed by vacuum deposition.

According to such a configuration, it is possible to obtain a stress transducer having high sensivity and high reliability by using an amorphous silicon thin film. The gauge factor of this stress tranducer was 47.

Heretofore, since amorphous semiconductors, such as an amorphous silicon thin film and the like, have poor crystallinity, they cannot be used for a strain gauge without performing heat treatment. To the contrary, according to the present method, laser irradiation not only performs impurity diffusion, but also can improve crystallinity and sensitivity. Hence, it is possible to obtain a stress transducer which is easy to produce and has high reliability without passing through a high-temperature process and a photolithographic process for patterning. Accordingly, it is possible to use organic materials, such as plastics and the like, which could not previously be used from the viewpoint of heat-resistant and chemical-resistant properties, and to largely reduce cost.

Since organic materials are easy to process compared with single-crystal semiconductors, it becomes possible to provide a monobloc molded body of a strain producing member and a seating, and it becomes unnecessary to perform bonding of a strain producing member to a seating and the like.

Although it is possible to provide a monobloc formed body of a strain producing member and a seating made of a metal material, there is a limit in processing for providing a thin strain producing member. To the contrary, since organic materials have better workability than metal materials and can be formed into thinner shapes, it is possible to perform measurement for lower load.

Furthermore, since organic materials are nonconductive, it becomes unnecessary to provide an insulating film which must intervene between a strain producing member and a gauge member as in the case of using a semiconductor or a metal for the strain producing member.

In the above-described embodiment, when a strain gauge made of an impurity diffused pattern is formed within an amorphous silicon thin film formed on a surface of a diaphragm made of polyether sulfonic resin, $B_2H_6$ which has been adsorbed on the surface of the amorphous silicon thin film by placing the film in an atmosphere of $B_2H_6$ gas is used as a diffusion source. However, as will be shown in the next modified example, also effective is a method in which a thin film of amorphous boron hydride (a-B:H) is deposited on the surface of the amorphous silicon thin film, laser irradiation is performed with making this film as a diffusion source, and a strain gauge made of an impurity diffused pattern is formed within the amorphous silicon thin film.

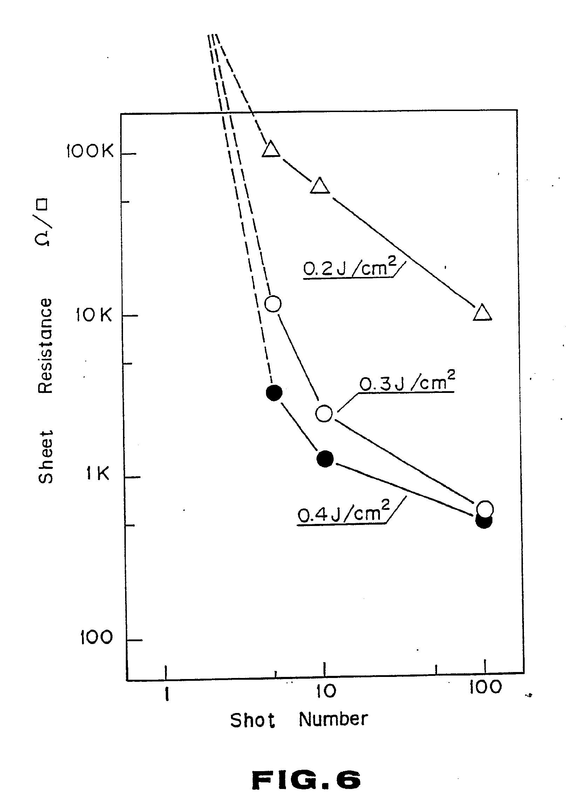

The relationship between shot number and sheet resistance in the above-described laser irradiating process as a result of measurement with changing laser energy is shown in FIG. 6. As is apparent from FIG. 6, sheet resistance becomes smaller as laser energy is larger and shot number is larger. Hence, it is possible to obtain a desired value of sheet resistance by adjusting laser energy and shot number.

Example 4

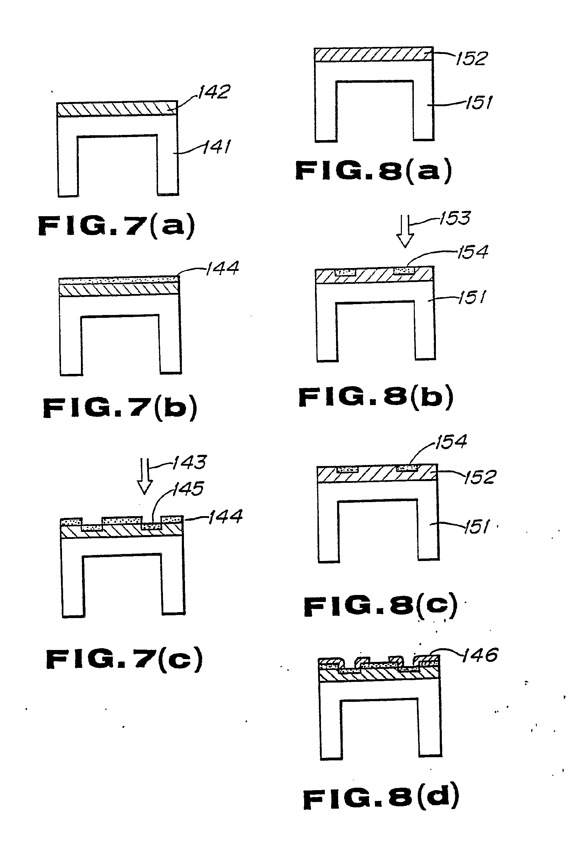

The process in this method is identical to the process of Example 3 shown in FIG. 5(a) up to the process in which an amorphous silicon thin film 142 6000 Å thick is deposited on a surface of a diaphragm 141 made of polyether sulfonic

23

resin by an RF sputtering method (see FIG. 7(a)).

Next, as shown in FIG. 7(b), a thin film 144 of amorphous boron hydride 50 - 100 Å thick as a diffusion source is deposited on the surface of the amorphous silicon thin film 142 by a plasma CVD method using $B_2H_6$ gas as material gas.

Subsequently, as shown in FIG. 7(c), the diaphragm 141 is placed in the laser irradiating room. After exhausting air, 10 shots of laser light 143 having the energy of 0.2 $J/cm^2$ are projected upon a strain gauge forming region in an atomsphere of inert gas to diffuse B into the amorphous silicon thin film 142, and a strain gauge 145 is thus formed. Although the thin film 144 of amorphous boron hydride remains in non-irradiated regions as it is, the remaining film may be left as it is without being removed because the thin film of amorphous boron hydride is a material which has high resistivity. However, the remaining film must be removed in some cases after laser irradiation depending on the kind of the thin film as a diffusion source.

Finally, as shown in FIG. 7(d) (in the same manner as in FIG. 5(c)), an interconnection pattern 146 made of an aluminum layer is formed by vacuum deposition.

Also by this method, as in Example 3 described above, it is possible to obtain a stress transducer which is easy

24

to produce and has high reliability.

Although, in the present embodiment, a thin film of amorphous boron hydride formed by a plasma CVD method is used as a thin film as a p-type diffusion source, a thin film as an n-type diffusion source, such as a thin film of amorphous phosphorus hydride (a-P:H) made from phosphine ($PH_3$) as material gas, or the like, may also be used.

As for the method for forming a thin film as a diffusion source, it is also possible to use a spin coating method besides the methods described above. In this method, a coating liquid for forming a coating which is made by dissolving an n-type impurity, such as phosphorus or the like, a p-type impurity, such as boron or the like, and an agent for forming a glassy material, such as $SiO_2$ or the like, in an organic solvent, such as alcohol or the like, is supplied on the surface of the semiconductor substrate, which is turned by a spinner to perform uniform coating. By changing the density of the coating liquid and the number of revolution of the spinner, it is possible to easily control the thickness of coating. Accordingly, by controlling the thickness of the impurity as the diffusion source, it is possible to easily control the density of the impurity in a strain gauge.

Example 5

As a modified example of Example 3, it is also possible to constitute the semiconductor substrate itself by a semiconductor thin film including an impurity.

That is, first, as shown in FIG. 7(a), a thin film 152 of boron-doped amorphous silicon 6000 Å thick is deposited on a surface of a diaphragm 151 made of polyether sulfonic resin by a sputtering method using silicon containing B as a target. As for deposition conditions at this time, sintered polycrystal silicon containing 1 % B is used as a target, and sputtering is performed at the RF power of 300 W for 1 hour.

Next, as shown in FIG. 7(b), the diaphragm 151 on which the thin film 152 of boron-doped amorphous silicon has been formed is placed in the laser irradiating room. After exhausting air, the main body 101 of the irradiating room is maintained at an atmosphere of 50-Torr inert gas, and 10 shots of laser light 153 having the energy of 0.2 J/cm$^2$ are projected upon a strain guage forming region to form a low-resistance strain gauge 154 made of boron-doped polycrystal silicon in a part of the thin film 152 of boron-doped amorphous silicon. In this case, the depth of the strain gauge 154, that is, diffused depth was 0.4 - 0.8 μm, sheet resistance was several hundreds of $\Omega/cm^2$, and resistivity was 10$^{-2}$ $\Omega$ cm.

Finally, as shown in FIG. 7(c), an interconnection pattern 155 made of an aluminum layer is formed by vacuum

26

deposition.

In this method, since an impurity is simultaneously included at the moment of depositing a semiconductor substrate, the number of processes is reduced, and it is possible to easily obtain a stress transducer having high reliability.

The method of forming a semiconductor thin film including an impurity is not limited to a sputtering method, but vacuum deposition, plasma CVD and the like, may also be utilized. If vacuum deposition is utilized, a target including an impurity, such as B, P or the like, is used. If a plasma CVD method is utilized, a method is adopted in which $B_2H_6$ gas or $PH_3$ gas is mixed with $SiH_4$ or $Si_2H_6$, and a film is formed by decomposition.

Although, in the above-described embodiment, polyether sulfonic resin is used for the diaphragm, various kinds of reinforced plastics (also termed high-functional resins) called in general "engineering plastics" , such as polyacetal and the like, which are mainly used in place of metals as parts for machines, apparatuses and the like, and housings in the industrial field; may also be used.

Examples of organic materials (engineering plastics) used in the strain producing member are shown in Table 1.

## Table 1

| Classification | | Example |
|---|---|---|
| General-purpose engineering plastics (thermoplastic) (heat resistance: 100 - - 140 °C) | Crystal-line | Nylon (N6, N66, N11) Polyacetal (POM) Polybutylene tere-phthalate (PBT) Reinforced polyethy-lene terephthalate (Reinforced PET) |
| | Noncrys-talline | Polycarbonate (PC) Modified polyphenyle-ne oxide (Modified PPO) |
| Thermo-plastic | Crystal-line | Polyphenylene sulfide (PPS) Polyetherether ketone (PEEK) Thermoplastic fluoro-resin(PFA, ETFE etc.) |

Table 1 (continued)

| | | | Polyarylate |
|---|---|---|---|
| Special Engineering Plastics (Heat resistance: 150 °C or more) | Nonbridge-type | Noncrystalline | Polysulfone (PSF) |
| | | | Polyether sulfone (PES) |
| | | | Polyether imide (PEI) |
| | | | Polyamide imide (PAI) |
| | | Non-thermoplastic (Mainly for compression molding) | Polytetrafluoroethylene (PTFE) |
| | | | All aromatic polyesther |
| | | | Polyimide (PI) |
| | Bridge type | | Polyamino bismaleimide (PABM) |
| | | | Triazine resin |
| | | | Bridged polyimide (PI) |
| | | | Bridged polyamide imide |

Among such organic materials, most suitable materials for a strain producing member are noncrystalline general-purpose engineering plastics and thermoplastic engineering plastics which are easy to process, can be subjected to injection molding, are excellent in mass production capability, and have high freedom in shapes. These plastics have excellent thermal stability for their mechanical properties.

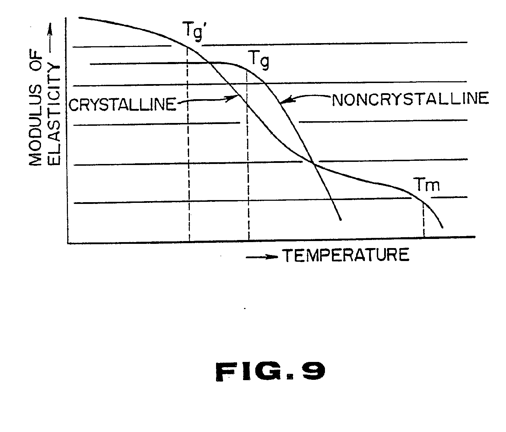

On the other hand, as shown in FIG. 9 which indicates the relationship between temperature and modulus of elasticity for crystalline engineering plastics and noncrystalline engineering plastics, although crystalline plastics are inferior to noncrystalline plastics in thermal stability for mechanical properties, crystalline plastics have larger mechanical strength. Hence, crystalline plastics can constitute an excellent strain producing member depending on a temperature range for application.

Furthermore, in the above-described embodiments, organic materials other than engineering plastics, such as acrylic resins, vinyl chloride and the like, may also be utilized depending on a temperature for application. Metals, such as stainless steel and the like, may of course be also utilized.

As described before, as for the process for introducing an impurity, there are the following methods.

(1) A method of adsorbing an impurity on a surface of a semiconductor substrate.

(2) A method of forming a film including an impurity (a film as a diffusion source) on a surface of a semiconductor substrate.

(3) A method of including an impurity into a semiconductor substrate at the moment of forming the semiconductor substrate. Any of these methods may be properly selected in accordance with a material constituting a strain producing member and a material constituting a strain gauge. Some examples are shown in Table 2.

Table 2

| Strain producing member | Semiconductor (Property) | Substrate | Strain gauge | Method for introducing an impurity |
|---|---|---|---|---|
| Single crystal semiconductor | Strain producing member (Single crystal semiconductor) | Intrinsic | P-type or n-type | 1, 2 |
| | | P-type | N-type | |
| | | N-type | P-type | |
| Material having heat resistance, such as metal and the like | Polycrystal semiconductor | Intrinsic | P-type or n-type | 1, 2 |
| | | P-type | P-type | 1, 2, 3 |
| | | | N-type | 1, 2 |
| | | N-type | P-type | 1, 2 |
| | | | N-type | 1, 2, 3 |
| Any material such as metal, plastic and the like | Amorphous semiconductor | Intrinsic | P-type or n-type | 1, 2 |
| | | P-type | P-type | 1, 2, 3 |
| | | | N-type | 1, 2 |
| | | N-type | P-type | 1, 2 |

Table 2 (continued)

type        N-type        1, 2, 3

------------------------------------------------------------------

Possibility of Industrial Application

As explained above, since the stress transducer according to the present invention may use any material for its seating and may be formed at a low temperature, it is possible to widely use it for transformation of stress in various fields. Particularly, the inventive stress transducer is effective as a stress transducer in a device which requires a strain guage pattern having high accuracy, such as a pressure sensor, an acceleration sensor and the like.

## Claims

(1) A stress transducer, characterized in that it comprises a strain producing member made of a single-crystal semiconductor, and a strain-gauge pattern formed by selectively performing laser irradiation upon a surface of said strain producing member in a state in which an impurity exists on the surface.

(2) A stress transducer, characterized in that it comprises a strain producing member made of a metal or an alloy, a semicoductor substrate disposed on a surface of said strain producing member, and a strain-gauge pattern formed by selectively performing laser irradiation upon a surface of said semiconductor substrate in a state in which an impurity exists on the surface.

(3) A stress transducer, characterized in that it comprises a strain producing member made of an organic material, a semiconductor substrate disposed on a surface of said strain producing member, and a strain-gauge pattern formed by selectively performing laser irradiation upon a surface of said semiconductor substrate in a state in which an impurity exists on the surface.

(4) A method of producing a stress transducer having a strain producing member and a strain-gauge pattern disposed on a surface of the strain producing member, characterized in that it comprises:

34

a strain producing member forming process for forming the strain producing member made of a single-crystal semiconductor;

an impurity introducing process for introducing an impurity in the surface of said strain producing member; and

a laser irradiation process for selectively performing laser irradiation on the surface of said strain producing member in which the impurity has been introduced to form a strain gauge made of a pattern of an impurity region.

(5) A method of producing a stress transducer having a strain producing member and a strain-gauge pattern disposed on a surface of the strain producing member, characterized in that it comprises:

a strain producing member forming process for forming the strain producing member;

a semiconductor substrate forming process for forming a semiconductor substrate on said strain producing member;

an impurity introducing process for introducing an impurity on a surface of said semiconductor substrate; and

a laser irradiation process for performing laser irradiation upon said semiconductor substrate in which the impurity has been introduced to form a strain gauge made of a pattern of an impurity region.

FIG.1(a)

FIG.1(b)

FIG.1(c)

FIG.1(d)

FIG.1(e)

**FIG.2**

Energy Density ( J/cm² )

**FIG.3(a)**

FIG.3(b)

FIG.4(a)

FIG.5(a)

FIG.4(b)

FIG.5(b)

FIG.4(c)

FIG.5(c)

**FIG.6**

FIG.7(a)

FIG.7(b)

FIG.7(c)

FIG.8(a)

FIG.8(b)

FIG.8(c)

FIG.8(d)

FIG.9

FIG.10(a)

FIG.10(b)

FIG.10(c)

FIG.10(d)

FIG.10(e)

FIG.10(f)

FIG.10(g)

FIG.11(a)

FIG.11(b)

FIG.11(c)

FIG.11(d)

**FIG.12**

**FIG.13**

# INTERNATIONAL SEARCH REPORT

International Application No PCT/JP89/00600

## I. CLASSIFICATION OF SUBJECT MATTER (if several classification symbols apply, indicate all) ⁶

According to International Patent Classification (IPC) or to both National Classification and IPC

Int. Cl⁴    H01L29/84, H01L21/22

## II. FIELDS SEARCHED

### Minimum Documentation Searched ⁷

| Classification System | Classification Symbols |
|---|---|
| IPC | H01L29/84, H01L21/22 |

### Documentation Searched other than Minimum Documentation to the Extent that such Documents are Included in the Fields Searched ⁸

| | |
|---|---|
| Jitsuyo Shinan Koho | 1965 – 1989 |
| Kokai Jitsuyo Shinan Koho | 1971 – 1989 |

## III. DOCUMENTS CONSIDERED TO BE RELEVANT ⁹

| Category * | Citation of Document, ¹¹ with indication, where appropriate, of the relevant passages ¹² | Relevant to Claim No. ¹³ |
|---|---|---|
| Y | JP, A, 55-52221 (Toshiba Corp.) 16 April 1980 (16. 04. 80) Page 2, upper right column, line 18 to page 2, lower left column, line 17, page 3, upper left column, line 12 to page 3, upper right column, line 15 (Family : none) | 1 – 5 |
| Y | JP, A, 57-159068 (General Motors Corporation) 1 October 1982 (01. 10. 82) Page 2, lower right column, lines 4 to 18 & EP, A1, 60427 | 1, 4 |
| Y | JP, A, 61-163667 (Nagano Keiki Seisakusho, Ltd.) 24 July 1986 (24. 07. 86) Page 2, lower left column, line 15 to page 2, lower right column, line 5 (Family : none) | 2, 5 |

* Special categories of cited documents: ¹⁰

"A" document defining the general state of the art which is not considered to be of particular relevance

"E" earlier document but published on or after the international filing date

"L" document which may throw doubts on priority claim(s) or which is cited to establish the publication date of another citation or other special reason (as specified)

"O" document referring to an oral disclosure, use, exhibition or other means

"P" document published prior to the international filing date but later than the priority date claimed

"T" later document published after the international filing date or priority date and not in conflict with the application but cited to understand the principle or theory underlying the invention

"X" document of particular relevance; the claimed invention cannot be considered novel or cannot be considered to involve an inventive step

"Y" document of particular relevance; the claimed invention cannot be considered to involve an inventive step when the document is combined with one or more other such documents, such combination being obvious to a person skilled in the art

"&" document member of the same patent family

## IV. CERTIFICATION

| Date of the Actual Completion of the International Search | Date of Mailing of this International Search Report |
|---|---|
| September 4, 1989 (04. 09. 89) | September 18, 1989 (18. 09. 89) |

| International Searching Authority | Signature of Authorized Officer |
|---|---|
| Japanese Patent Office | |

Form PCT/ISA/210 (second sheet) (January 1985)

FURTHER INFORMATION CONTINUED FROM THE SECOND SHEET

| | | |
|---|---|---|
| Y | JP, A, 60-195402 (Kabushiki Kaisha Fuji Denki Sogo Kenkyusho) 3 October 1985 (03. 10. 85) Page 2, upper left column, line 16 to page 2, upper right column, line 15 (Family : none) | 3, 5 |

V.☐ OBSERVATIONS WHERE CERTAIN CLAIMS WERE FOUND UNSEARCHABLE [1]

This international search report has not been established in respect of certain claims under Article 17(2) (a) for the following reasons:

1.☐ Claim numbers ............, because they relate to subject matter not required to be searched by this Authority, namely:

2.☐ Claim numbers ............, because they relate to parts of the international application that do not comply with the prescribed requirements to such an extent that no meaningful international search can be carried out, specifically:

3.☐ Claim numbers ............, because they are dependent claims and are not drafted in accordance with the second and third sentences of PCT Rule 6.4(a).

VI.☐ OBSERVATIONS WHERE UNITY OF INVENTION IS LACKING [2]

This International Searching Authority found multiple inventions in this international application as follows:

1.☐ As all required additional search fees were timely paid by the applicant, this international search report covers all searchable claims of the international application.

2.☐ As only some of the required additional search fees were timely paid by the applicant, this international search report covers only those claims of the international application for which fees were paid, specifically claims:

3.☐ No required additional search fees were timely paid by the applicant. Consequently, this international search report is restricted to the invention first mentioned in the claims; it is covered by claim numbers:

4.☐ As all searchable claims could be searched without effort justifying an additional fee, the International Searching Authority did not invite payment of any additional fee.

Remark on Protest

☐ The additional search fees were accompanied by applicant's protest.

☐ No protest accompanied the payment of additional search fees.

Form PCT/ISA/210 (supplemental sheet (2)) (January 1985)